(19) Europäisches Patentamt
European Patent Office
Office européen des brevets

(11) Publication number: **0 598 320 A2**

(12) **EUROPEAN PATENT APPLICATION**

(21) Application number: **93118217.4**

(51) Int. Cl.$^5$: **G03F 7/022**

(22) Date of filing: **10.11.93**

(30) Priority: **11.11.92 JP 300902/92**

(43) Date of publication of application:
**25.05.94 Bulletin 94/21**

(84) Designated Contracting States:
**BE DE FR GB IT NL**

(71) Applicant: **SUMITOMO CHEMICAL COMPANY, LIMITED**
**Kitahama 4-chome 5-33**
**Chuo-ku Osaka 541(JP)**

(72) Inventor: **Osaki, Haruyoshi**
**10-3-311, Sonehigashinocho-2-chome**
**Toyonaka-shi(JP)**
Inventor: **Ebina, Chinehito**
**9-17, Sakuragaoka-4-chome**
**Minoo-shi(JP)**
Inventor: **Moriuma, Hiroshi**
**4-3, Gakuen Minami-2-chome**
**Nara-shi(JP)**
Inventor: **Uetani, Yasunori**
**10-3-350, Sonehigashinocho-2-chome**
**Toyonaka-shi(JP)**

(74) Representative: **VOSSIUS & PARTNER**
**Siebertstrasse 4**
**D-81675 München (DE)**

(54) **Positive resist composition.**

(57) According to the present invention, there is provided the following positive resist composition which is excellent in properties such as resolution, profile, depth of focus, etc. and free from scum:

a positive resist composition comprising (a) a novolac resin obtained through a condensation reaction of an aldehyde compound and a mixture of phenol compounds comprising m-cresol, p-cresol and 2,5-xylenol, (b) a light-sensitive quinonediazide material containing the quinonediazidesulfonic acid diester of the compound having not less than three phenolic hydroxyl groups in an amount of 40% or more as expressed in terms of pattern area measured by high performance liquid chromatography, and (c) an alkali-soluble compound having a molecular weight of lower than 900.

EP 0 598 320 A2

The present invention relates to a positive resist composition sensitive to radiations such as ultraviolet rays, far ultraviolet rays including excimer laser and the like.

Recently, with a rise in the integration level of integrated circuits, formation of pattern of sub-micron order is required. As its result, a positive resist composition more excellent in resolution, profile, depth of focus, etc. is demanded. Particularly in the production of 16-64 MDRAMs, it is necessary to resolve a pattern having a line width of 0.5 µm or less with a good profile and a broad depth of focus.

In JP-A-1-177032, there is mentioned a radiation-sensitive resin composition comprising (A) an alkali-soluble novolac resin which is formed through a co-condensation reaction of (a) at least one member selected from p-cresol, 2,5-xylenol, 3,5-xylenol and 2,3,5-trimethylphenol, (b) m-cresol and (c) an aldehyde and obtained by partially removing low molecular weight components, (B) at least one member selected from 1,2-quinonediazidesulfonic acid ester of optionally substituted trihydroxybenzophenone, 1,2-quinonediazidesulfonic acid ester of optionally substituted tetrahydroxybenzophenone, 1,2-quinonediazidesulfonic acid ester of optionally substituted pentahydroxybenzophenone and 1,2-quinonediazidesulfonic acid ester of optionally substituted hexahydroxybenzophenone and (C) an optionally substituted polyhydroxybenzophenone, wherein the content of said (C) polyhydroxybenzophenone is 1 to 50 parts by weight per 100 parts by weight of said alkali-soluble novolac resin. Further, in JP-A-2-19846, there is mentioned a positive resist composition comprising a novolac resin and a quinonediazidesulfonic acid ester of a phenol compound, provided that, in the high performance liquid chromatographic chart (measured with 254 nm ultraviolet detector) of the quinonediozidesulfonic acid ester of the phenol compound, the pattern area of quinonediazidesulfonic acid diesters of phenol compounds having 3 or more phenolic hydroxyl groups occupies 50% or more of the total pattern area of said quinonediazidesulfonic acid ester of said phenol compound.

In these compositions, however, a pattern having a line width of 0.5 µm or less cannot be resolved with a good profile and a large depth of focus.

It is an object of the present invention to provide a positive resist composition excellent in properties such as resolution, profile and depth of focus, and free from scum.

According to the present invention, there is provided a positive resist composition comprising:

(a) a novolac resin obtainable through a condensation reaction of an aldehyde compound with a mixture of phenol compounds comprising m-cresol, p-cresol and 2,5-xylenol;

(b) a light-sensitive quinonediazide material containing the quinonediazidesulfonic acid diester of a compound having not less than three phenolic hydroxyl groups, provided that a peak area corresponding to said quinonediazidesulfonic acid diester of the compound having not less than three phenolic hydroxyl groups is not less than 40% of all peak areas corresponding to the light-sensitive quinonediazide material in a high performance liquid chromatograph spectrum measured with a detector for UV of 254 nm, and

(c) an alkali-soluble compound having a molecular weight of lower than 900.

As preferable novolac resin, those obtainable through a condensation reaction of a mixture of phenol compounds comprising m-cresol, p-cresol and 2,5-xylenol wherein the proportion of 2,5-xylenol is from 10% to 50% by mole based on the whole moles of the mixture of phenol compounds with an aldehyde compound comprising at least one member selected from the group including formaldehyde, acetaldehyde, benzaldehyde, glyoxal and salicyl aldehyde can be referred to.

When the proportion of 2,5-xylenol in a mixture of phenol compounds is smaller than 10% by mole, appearance of scum tends to be promoted. When the proportion of 2,5-xylenol is larger than 50% by mole, sensitivity tends to decrease. Preferably, the molar ratio of m-cresol to p-cresol is from 30:70 to 95:5.

As the aldehyde compound, formaldehyde is preferable. The condensation reaction is carried out in the conventional manner. The condensation reaction is carried out at a temperatuer of 60 to 120 °C for 2 to 30 hours. As the catalyst, inorganic acids such as hydrochloric acid, sulfuric acid and phosphoric acid, organic acids such as oxalic acid, acetic acid and p-toluenesulfonic acid, and divalent metal salts such as zinc acetate are used. The condensation reaction is carried out either in the presence or absence of reaction solvent.

As the novolac resin, a resin having an area in a GPC pattern (measured using a detector for UV of 254 nm) of a range in that a molecular weight as converted to polystyrene is not larger than 900 not exceeding 25%, more preferably not exceeding 20% of a whole pattern area excluding the unreacted phenol compounds is preferred. Such preferred novolac resin can be obtained by a known fractionation method.

The fractionation is carried out by a method which comprises dissolving a novolac resin obtainable by the condensation reaction in a good solvent such as an alcohol (for example, methanol or ethanol), a ketone (for example, acetone, methyl ethyl ketone or methyl isobutyl ketone), an ethylene glycol ether, an ether ester (for example, ethyl cellosolve acetate) or tetrahydrofuran and pouring the resulting solution in water to precipitate the resin or a method which comprises pouring the solution in a solvent such as pentane,

hexane or heptane to separate the resulting mixture into two phases.

Novolac resins other than the above may be mixed into the positive resist composition of the present invention, unless the effects of the present invention are not deteriorated.

The light-sensitive quinonediazide materials such as quinonediazidesulfonic acid ester of a compound having at least three phenolic hydroxyl groups or quinonediazidesulfonic acid ester of a phenol compound having at least two phenolic hydroxyl groups can be produced by, for example, reacting 1,2-naphthoquinonediazidesulfonic acid halide or benzoquinonediazidesulfonic acid halide with a compound having at least three phenolic hydroxyl groups or a compound having at least two phenolic hydroxyl groups, respectively, in the presence of, for example, a weak alkali.

Preferable examples of the compound having at least three phenolic hydroxyl groups include oxyflavans including the compounds mentioned on page 4 of JP-A-4-50851 (corresponding to EP-A-461 654) as the following formula:

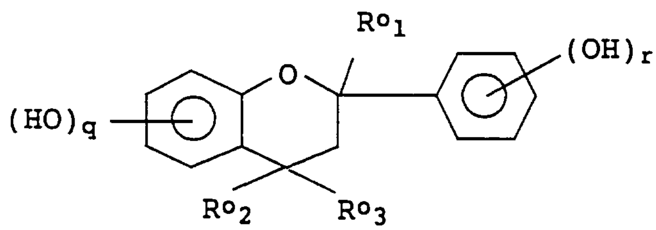

wherein q represents an integer of 0-4, r represents an integer of 1-5, and $R^o_1$ , $R^o_2$ and $R^o_3$ independently of one another each represents hydrogen atom, alkyl group, alkenyl group, cyclohexyl group or aryl group; and the compounds mentioned in JP-A-3-185447 (corresponding to EP-A-525 185) as the following general formula (I):

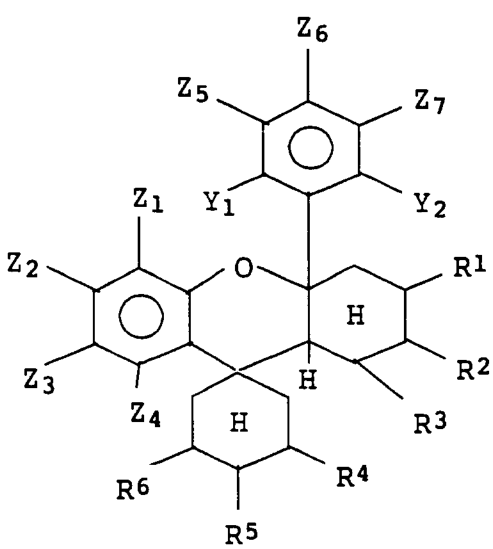

wherein $Y_1$, $Y_2$ and $Z_1$ to $Z_7$ independently of one another each represents hydrogen atom, hydroxyl group or $C_1$-$C_4$ alkyl group optionally substituted by halogen, provided that at least one of $Y_1$ and $Y_2$ is hydroxyl group and at least two of $Z_1$ to $Z_7$ are hydroxyl groups, and $R_1$ to $R_6$ independently of one another each represents hydrogen atom, $C_1$-$C_{10}$ alkyl group, $C_2$-$C_4$ alkenyl group, cycloalkyl group or aryl group; as well as novolac type reaction products having 3-7 phenol nuclei obtained from a phenol compound and an aldehyde compound.

Concrete examples of said novolac type reaction product include the compounds represented by the following formulas:

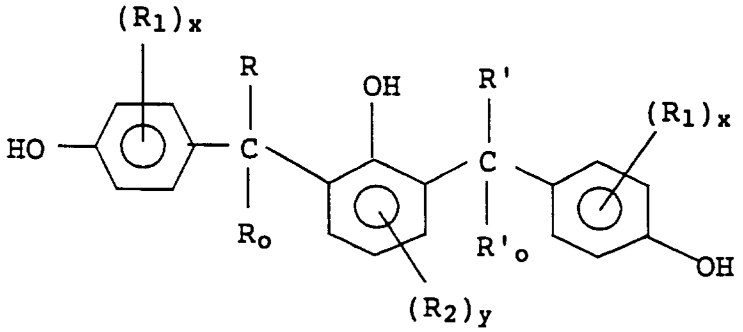

or

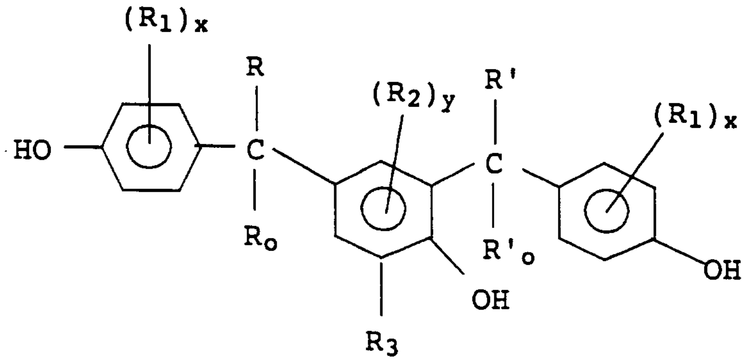

wherein $R_1$ and $R_2$ independently of one another each represents hydrogen atom, halogen atom, $-OCOR_3$ or optionally substituted alkyl or alkoxy group, in which $R_3$ represents an optionally substituted alkyl or phenyl group, x and y independently of one another each represents an integer of 1-3, and R, $R_o$, R' and $R'_o$ independently of one another each represents hydrogen atom, alkyl group or phenyl group; and the compounds represented by the following formula:

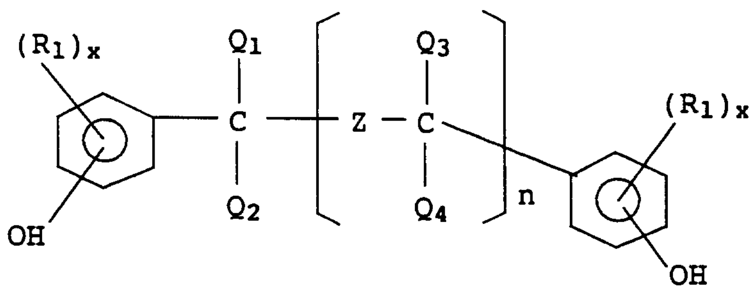

wherein $R_1$ and x are as defined above, $Q_1$ to $Q_4$ independently of one another each represents hydrogen atom, alkyl group or phenyl group, Z represents a group of the following formula:

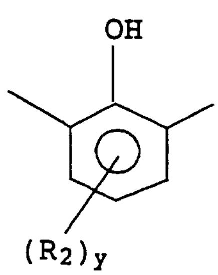

or

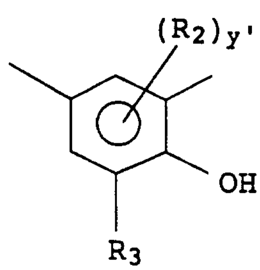

in which $R_2$ and $R_3$ are as defined above, y' represents 1 or 2, and n represents an integer of 2-5.

A preferred amount of the quinonediazidesulfonic acid diester of a compound having at least three phenolic hydroxyl groups to the total of a light-sensitive quinonediazide material is not less than 40%, more preferably is not less than 50% as expressed in terms of pattern area ratio in a high performance liquid chromatograph spectrum measured by UV detector with the wavelength of 254 nm.

The light-sensitive quinonediazide material may contain a quinonediazidesulfonic acid ester of a phenol compound having at least two phenolic hydroxyl groups in addition to said quinonediazidesulfonic acid diester of a compound having at least three phenolic hydroxyl groups. In such a case, the content of complete ester compound (a compound in which all the hydroxyl groups are esterified) in the quinonediazidesulfonic acid ester of phenol compound having at least two phenolic hydroxyl groups should be preferably 5% or more based on the total light-sensitive quinonediazide material as expressed in terms of pattern area ratio in a high performance liquid chromatograph spectrum measured by UV detector with the wavelength of 254 nm.

Examples of said phenol compound having two or more phenolic hydroxyl groups include the phenol compounds mentioned on page 3 of JP-A-2-103543 (corresponding to EP-A-363 978) as the following general formula:

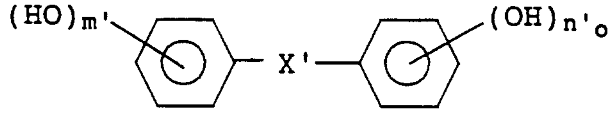

wherein X' represents a group of the following formula:

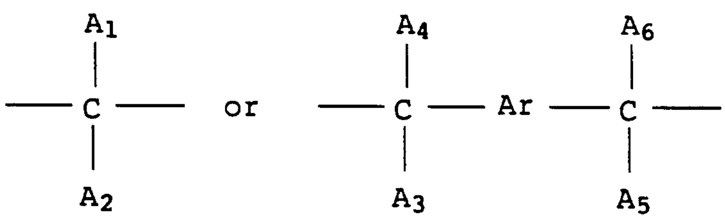

in which $A_1$ to $A_6$ independently of one another each represents hydrogen atom, $C_{1-8}$ alkyl group (preferably $C_{1-4}$ alkyl group), $C_{6-18}$ aryl group (preferably $C_{6-14}$ aryl group), $C_{2-8}$ alkenyl group (preferably $C_{2-5}$ alkenyl group) or cyclohexyl group and Ar represents a divalent aromatic group having 6-18 carbon atoms (preferably 6-14 carbon atoms), and m' and $n'_o$ each represents an integer of 0 or greater, provided that $2 \leqq m'+n'_o \geqq 6$, preferably $2 \leqq m'+n'_o \geqq 4$ and more preferably $2 \leqq m'+n'_o \geqq 3$; the compounds mentioned in JP-A-2-32352 (corresponding to EP-A-351 849) as the following general formulas (I) or (II):

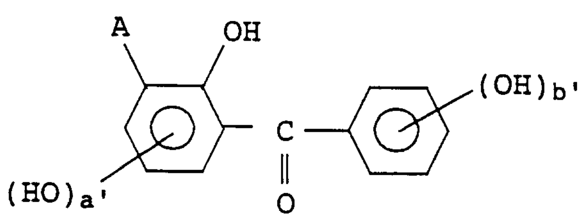

(I)

or

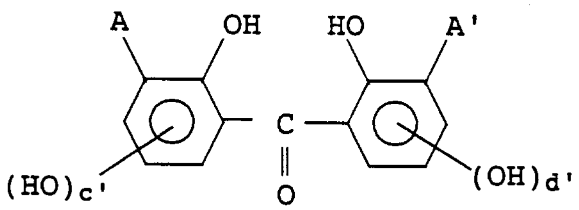

(II)

wherein a', b', c' and d' independently of one another each represents a number of 0-3, provided that when a' is 0 or 3, b' is a number of 0-3, when a' is 1 or 2, b' is a number of 0, 1 or 2, and a' + b' and c' + d' are both 2 or greater, and A and A' independently of one another each represents alkyl or aryl group; and the compounds mentioned in JP-A-2-269351 (corresponding to EP-A-341 608) as the following general formula (I):

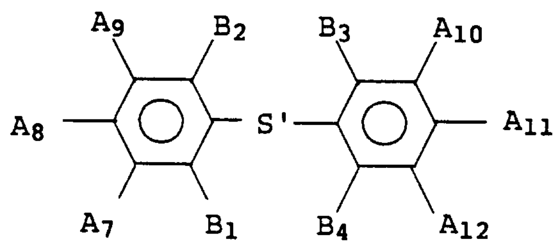

wherein $B_1$ to $B_4$ independently of one another each represents hydrogen atom, alkyl group, halogen atom or hydroxyl group, provided that at least one of $B_1$ to $B_4$ is hydroxyl group, $A_7$ to $A_{12}$ independently of one another each represents hydrogen atom, alkyl group, aryl group, halogen atom or hydroxyl group, provided that at least one of $A_7$ to $A_{12}$ is hydroxyl group, and S' represents a group of the following formula:

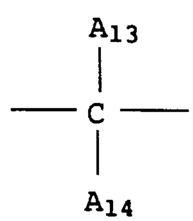

in which $A_{13}$ and $A_{14}$ independently of one another each represents hydrogen atom, alkyl group, alkenyl group, cycloalkyl group, alkoxy group or aryl group, provided that when at least one of $A_{13}$ and $A_{14}$ is hydrogen atom, the ortho position of the hydroxyl group located in the ortho position of S' is substituted by alkyl or aryl group.

The light-sensitive quinonediazide material is used preferably in an amount of 10 to 50% by weight based on the total solid components (novolac resin, light-sensitive quinonediazide material, alkali-soluble compound having a molecular weight of lower than 900, etc.) in the positive resist composition.

As the alkali-soluble compound having a molecular weight of lower than 900, those showing weak absorption peaks in the wavelength range of 340 to 375 nm and having at least two phenolic hydroxyl groups are preferable. More preferable examples of said alkali-soluble compound include the compounds mentioned in JP-A-2-275955 (correspodning to EP-A-358 871) as the following general formula (I):

X-$\alpha$-H

wherein X represents

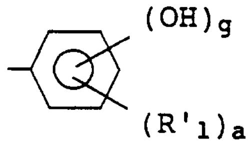

or

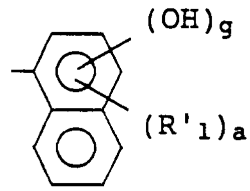

and α represents a divalent group containing the following repeating unit:

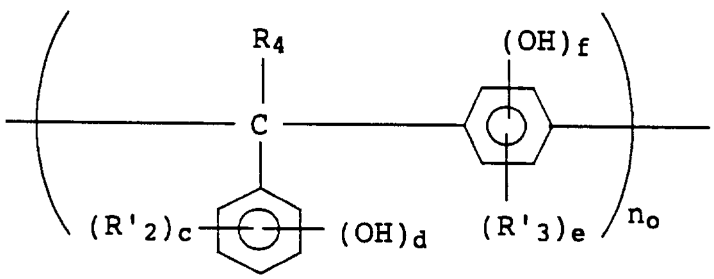

or

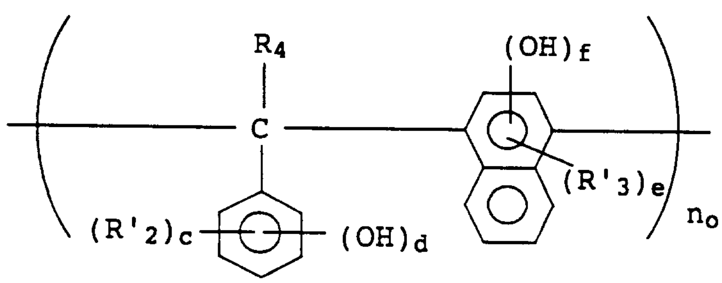

in which $n_o$ represents an integer of 1 or greater, a, b, c, d, e and f independently of one another each represents an integer of 0-3, provided that $d+f \geqq 1$, $R'_1$, $R'_2$ and $R'_3$ independently of one another each represents $C_1$-$C_{18}$ alkyl group, $C_1$-$C_{18}$ alkoxy group, carboxyl group or halogen atom, and $R_4$ represents hydrogen atom, $C_1$-$C_{18}$ alkyl group or aryl group; the compounds mentioned in JP-A-4-50851 (corresponding to EP-A-461 654) as the following general formula (I):

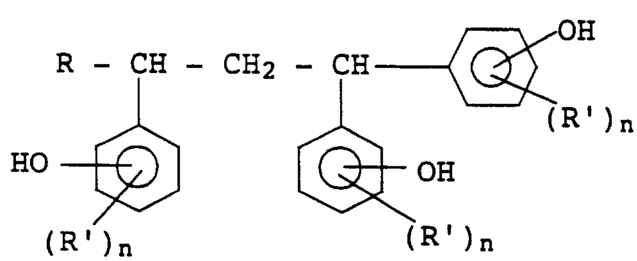

wherein R represents hydrogen atom, lower alkyl group or phenyl group, R' represents alkyl or alkoxy group, and n represents an integer of 0-3; and the compounds mentioned in JP-A-3-179353 (corresponding to EP-A-416 544) as the following general formula (I):

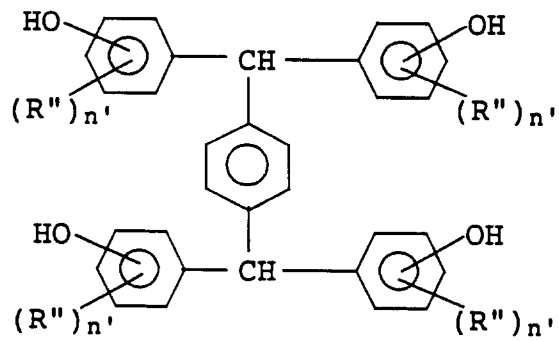

wherein R'' represents $C_1$-$C_5$ alkyl group or $C_1$-$C_5$ alkoxy group and n' represents an integer of 0-3.

Preferably, the alkali-soluble compound having a molecular weight of lower than 900 is used in an amount of 3 to 40% by weight based on the total solid components in the positive resist composition.

If necessary, additives conventionally used in this field of art such as dye, adhesion improver and the like may be added to the positive resist composition of the present invention.

As the solvent used in the preparation of positive resist solution, those evaporating at a suitable drying rate to give a uniform and smooth coating film are preferred. Examples of such solvent include glycol ether esters such as ethyl cellosolve acetate, propylene glycol monomethyl ether acetate and the like, the solvents mentioned on Page 6 of JP-A-2-220056, esters such as ethyl pyruvate, n-amyl acetate, ethyl lactate and the like, and ketones such as 2-heptanone and $\gamma$-butyrolactone.

These solvents are used either singly or in the form of a mixture of two or more members.

The present invention will be illustrated concretely by following examples. The invention is by no means limited by these examples which do not intended to limit the scope of the present invention. In the examples, parts are by weight.

Synthesis Example 1

A three-necked flask having a capacity of 3,000 ml was charged with 389.3 g of m-cresol, 97.3 g of p-cresol, 219.9 g of 2,5-xylenol, 657.1 g of methyl isobutyl ketone, 133.3 g of 10% aqueous solution of oxalic acid and 137.7 g of acetic acid. While heating and stirring the mixture in an oil bath kept at 100 °C, 436.2 g of 37.0% aqueous formaldehyde solution was dropwise added thereto over a period of 40 minutes, and the resulting mixture was further reacted for 15 hours. Then, the reaction mixture was washed with water and dehydrated to obtain 1,449 g of a solution of novolac resin in methyl isobutyl ketone. The novolac resin had a polystyrene-converted weight average molecular weight of 4,300 measured by GPC.

Synthesis Example 2

A three-necked flask having a capacity of 2,000 ml was charged with 279.2 g of m-cresol, 119.6 g of p-cresol, 171.0 g of 2,5-xylenol, 511 g of methyl isobutyl ketone, 51.8 g of 10% aqueous solution of oxalic acid and 107 g of acetic acid. While heating and stirring the mixture in an oil bath kept at 100 °C, 316 g of 37.0% aqueous formaldehyde solution was dropwise added thereto over a period of 40 minutes, and the resulting mixture was further reacted for 15 hours. Then, the reaction mixture was washed with water and dehydrated to obtain 1,175 g of a solution of novolac resin in methyl isobutyl ketone. The novolac resin had a polystyrene-converted weight average molecular weight of 4,500 measured by GPC.

Synthesis Example 3

A three-necked flask having a capacity of 3,000 ml was charged with 316.3 g of m-cresol, 170.3 g of p-cresol, 109.9 g of 2,5-xylenol, 555 g of methyl isobutyl ketone, 66 g of 10% aqueous solution of oxalic acid and 138 g of acetic acid. While heating and stirring the mixture in an oil bath kept at 100 °C, 331 g of 37.0% aqueous formaldehyde solution was dropwise added thereto over a period of 40 minutes, and the resulting mixture was further reacted for 15 hours. Then, the reaction mixture was washed with water and dehydrated to obtain 1,200 g of a solution of novolac resin in methyl isobutyl ketone. The novolac resin had a polystyrene-converted weight average molecular weight of 4,200 measured by GPC.

Synthesis Example 4

A three-necked flask having a capacity of 2,000 ml was charged with 299.1 g of m-cresol, 99.7 g of p-cresol, 171.0 g of 2,5-xylenol, 511 g of methyl isobutyl ketone, 51.8 g of 10% aqueous solution of oxalic acid and 107 g of acetic acid. While heating and stirring the mixture in an oil bath kept at 100 °C, 328 g of 37.0% aqueous formaldehyde solution was dropwise added thereto over a period of 40 minutes, and the resulting mixture was further reacted for 15 hours. Then, the reaction mixture was washed with water and dehydrated to obtain 1,420 g of a solution of novolac resin in methyl isobutyl ketone. The novolac resin had a polystyrene-converted weight average molecular weight of 4,500 measured by GPC.

Synthesis Example 5

A bottom-releasable separable flask having a capacity of 3 liters was charged with 300 g of the solution of novolac resin in methyl isobutyl ketone obtained in Synthesis Example 1 (novolac resin content 48.6% by weight), to which were further added 996 g of methyl isobutyl ketone and 908 g of n-heptane. After stirring the resulting mixture at 60 °C for 30 minutes, the mixture was left to stand and separate into two liquid layers. The under layer was mixed with 290 g of 2-heptanone, and methyl isobutyl ketone and n-heptane were removed by means of evaporator to obtain a solution of a novolac resin in 2-heptanone. The novolac resin had a polystyrene-converted weight average molecular weight of 9,600 measured by GPC. An area in a GPC pattern of a range in that a molecular weight as converted to polystyrene is not larger than 900 was 16%.

Synthesis Example 6

A bottom-releasable separable flask having a capacity of 5 liters was charged with 450 g of the solution of novolac resin in methyl isobutyl ketone obtained in Synthesis Example 2 (novolac resin content 42.3% by weight), to which were further added 1,135 g of methyl isobutyl ketone and 1,096 g of n-heptane. After stirring the resulting mixture at 60 °C for 30 minutes, the mixture was left to stand and separate into two liquid layers. The under layer was mixed with 380 g of 2-heptanone, and methyl isobutyl ketone and n-heptane were removed by means of evaporator to obtain a solution of a novolac resin in 2-heptanone. The novola cresin had a polystyrene-converted weight average molecular weight of 9,000 measured by GPC. An area in a GPC pattern of a range in that a molecular weight as converted to polystyrene is not larger than 900 was 17%.

Synthesis Example 7

A bottom-releasable separable flask having a capacity of 3 liters was charged with 327 g of the solution of novolac resin in methyl isobutyl ketone obtained in Synthesis Example 3 (novolac resin content 44.6% by weight), to which were further added 942 g of methyl isobutyl ketone and 883 g of n-heptane. After stirring the resulting mixture at 60 °C for 30 minutes, the mixture was left to stand and separate into two liquid layers. The under layer was mixed with 290 g of 2-heptanone, and methyl isobutyl ketone and n-heptane were removed by means of evaporator to obtain a solution of a novolac resin in 2-heptanone. The novolac resin had a polystyrene-converted weight average molecular weight of 8,400 measured by GPC. An area in a GPC pattern of a range in that a molecular weight as converted to polystyrene is not larger than 900 was 18%.

Synthesis Example 8

A bottom-releasable separable flask having a capacity of 3 liters was charged with 351 g of the solution of novolac resin in methyl isobutyl ketone obtained in Synthesis Example 4 (novolac resin content 38.1% by weight), to which were further added 763 g of methyl isobutyl ketone and 770 g of n-heptane. After stirring the resulting mixture at 60 °C for 30 minutes, the mixture was left to stand and separate into two liquid layers. The under layer was mixed with 250 g of 2-heptanone, and methyl isobutyl ketone and n-heptane were removed by means of evaporator to obtain a solution of a novolac resin in 2-heptanone. The novolac resin had a polystyrene-converted weight average molecular weight of 8,700 measured by GPC. An area in a GPC pattern of a range in that a molecular weight as converted to polystyrene is not larger than 900 was 17%.

Synthesis Example 9

A three-necked flask having a capacity of 3,000 ml was charged with 243.3 g of m-cresol, 243.3 g of p-cresol, 219.9 g of 2,5-xylenol, 657 g of methyl isobutyl ketone, 133.3 g of 10% aqueous solution of oxalic acid and 138 g of acetic acid. While heating and stirring the mixture in an oil bath kept at 100 °C, 373 g of 37.0% aqueous formaldehyde solution was dropwise added thereto over a period of 40 minutes, and the resulting mixture was further reacted for 15 hours. Then, the reaction mixture was washed with water and dehydrated to obtain 1,430 g of a solution of novolac resin in methyl isobutyl ketone. The novolac resin had a polystyrene-converted weight average molecular weight of 4,300 measured by GPC.

Synthesis Example 10

A three-necked flask having a capacity of 2,000 ml was charged with 239.3 g of m-cresol, 159.5 g of p-cresol, 171 g of 2,5-xylenol, 511 g of methyl isobutyl ketone, 52 g of 10% aqueous solution of oxalic acid and 107 g of acetic acid. While heating and stirring the mixture in an oil bath kept at 100 °C, 309 g of 37.0% aqueous formaldehyde solution was dropwise added thereto over a period of 40 minutes, and the resulting mixture was further reacted for 15 hours. Then, the reaction mixture was washed with water and dehydrated to obtain 1,250 g of a solution of novolac resin in methyl isobutyl ketone. The novolac resin had a polystyrene-converted weight average molecular weight of 4,500 measured by GPC.

Synthesis Example 11

A three-necked flask having a capacity of 3,000 ml was charged with 259.2 g of m-cresol, 139.6 g of p-cresol, 219.9 g of 2,5-xylenol, 675 g of methyl isobutyl ketone, 133 g of 10% aqueous solution of oxalic acid and 138 g of acetic acid. While heating and stirring the mixture in an oil bath kept at 100 °C, 331 g of 37.0% aqueous formaldehyde solution was dropwise added thereto over a period of 40 minutes, and the resulting mixture was further reacted for 15 hours. Then, the reaction mixture was washed with water and dehydrated to obtain 1,500 g of a solution of novolac resin in methyl isobutyl ketone. The novolac resin had a polystyrene-converted weight average molecular weight of 4,200 measured by GPC.

Synthesis Example 12

A three-necked flask having a capacity of 2,000 ml was charged with 279.2 g of m-cresol, 119.6 g of p-cresol, 171 g of 2,5-xylenol, 511 g of methyl isobutyl ketone, 51.8 g of 10% aqueous solution of oxalic acid and 107 g of acetic acid. While heating and stirring the mixture in an oil bath kept at 100 °C, 316 g of 37.0% aqueous formaldehyde solution was dropwise added thereto over a period of 40 minutes, and the resulting mixture was further reacted for 15 hours. Then, the reaction mixture was washed with water and dehydrated to obtain 1,175 g of a solution of novolac resin in methyl isobutyl ketone. The novolac resin had a polystyrene-converted weight average molecular weight of 4,500 measured by GPC.

Synthesis Example 13

A bottom-releasable separable flask having a capacity of 3 liters was charged with 300 g of the solution of novolac resin in methyl isobutyl ketone obtained in Synthesis Example 9 (novolac resin content 43.5% by weight), to which were further added 345 g of methyl isobutyl ketone and 440 g of n-heptane. After stirring the resulting mixture at 60 °C for 30 minutes, the mixture was left to stand and separate into two liquid layers. The under layer was mixed with 290 g of 2-heptanone, and methyl isobutyl ketone and n-heptane were removed by means of evaporator to obtain a solution of a novolac resin in 2-heptanone. The novolac resin had a polystyrene-converted weight average molecular weight of 6,900 measured by GPC. An area in a GPC pattern of a range in that a molecular weight as converted to polystyrene is not larger than 900 was 18%.

Synthesis Example 14

A bottom-releasable separable flask having a capacity of 3 liters was charged with 330 g of the solution of novolac resin in methyl isobutyl ketone obtained in Synthesis Example 10 (novolac resin content 42.5% by weight), to which were further added 380 g of methyl isobutyl ketone and 484 g of n-heptane. After stirring the resulting mixture at 60 °C for 30 minutes, the mixture was left to stand and separate into two

liquid layers. The under layer was mixed with 290 g of 2-heptanone, and methyl isobutyl ketone and n-heptane were removed by means of evaporator to obtain a solution of a novolac resin in 2-heptanone. The novolac resin had a polystyrene-converted weight average molecular weight of 7,100 measured by GPC. An area in a GPC pattern of a range in that a molecular weight as converted to polystyrene is not larger than 900 was 20%.

Synthesis Example 15

A bottom-releasable separable flask having a capacity of 3 liters was charged with 330 g of the solution of novolac resin in methyl isobutyl ketone obtained in Synthesis Example 11 (novolac resin content 37.5% by weight), to which were further added 289 g of methyl isobutyl ketone and 422 g of n-heptane. After stirring the resulting mixture at 60°C for 30 minutes, the mixture was left to stand and separate into two liquid layers. The under layer was mixed with 250 g of 2-heptanone, and methyl isobutyl ketone and n-heptane were removed by means of evaporator to obtain a solution of a novolac resin in 2-heptanone. The novolac resin had a polystyrene-converted weight average molecular weight of 7,000 measured by GPC. An area in a GPC pattern of a range in that a molecular weight as converted to polystyrene is not larger than 900 was 20%.

Synthesis example 16

A bottom-releasable separable flask having a capacity of 5 liters was charged with 450 g of the solution of novolac resin in methyl isobutyl ketone obtained in Synthesis Example 12 (novolac resin content 42.3% by weight), to which were further added 502 g of methyl isobutyl ketone and 649 g of n-heptane. After stirring the resulting mixture at 60°C for 30 minutes, the mixture was left to stand and separate into two liquid layers. The under layer was mixed with 380 g of 2-heptanone, and methyl isobutyl ketone and n-heptane were removed by means of evaporator to obtain a solution of a novolac resin in 2-heptanone. The novolac resin had a polystyrene-converted weight average molecular weight of 6,700 measured by GPC. An area in a GPC pattern of a range in that a molecular weight was as converted to polystyrene is not larger than 900 was 21%.

Examples 1 to 11

According to the formulations shown in the following table, a novolac resin, a light-sensitive quinonediazide material and an alkali-soluble compound (in the table, simply referred to as "additive") were mixed and dissolved in 50 parts of 2-heptanone.

Each solution thus obtained was filtered with a tetrafluorethylene filter having a pore diameter of 0.2 µm to prepare a resist solution. Using a spinner, this resist solution was coated so as to form a resist film of 1.1 µm in thickness on a silicon wafer which had been rinsed in a usual way. Subsequently, the silicon wafer was baked at 90°C for one minute on a hot plate. Then, the wafer was exposed to light while stepwise changing the amount of exposure, by means of a reduction projection exposing apparatus having an exposure wavelength of 365 nm (i line) (manufactured by Nicon Co., NSR 1755i7A NA = 0.5).

Then, the wafer was baked at 110°C for one minute on a hot plate. Then, it was developed for one minute with SOPD (developing solution; product of Sumitomo Chemical Co., Ltd.) to obtain a positive pattern. Thereafter, a cross section of the line-and-space pattern of 0.45 µm was obserbed by a scanning electron microscope. From an exposure time at which the line-and-space ratio was achieved at the best focus, sensitivity was evaluated. A resolution was evaluated from the minimum line-and-space width which was separated without film thickness decrease at the above exposure amount. A profile and a scum were evaluated by observing, with a scanning electron microscope, the cross-sectional shape of a 0.45 µm line-and-space pattern at the above exposure amount.

A depth of focus was determined by measuring, with a scanning electron microscope, a degree of focus shifting at which the 0.40 µm line-and-space pattern could be resolved at the above exposure amount without film thickness decrease.

| Example No. | Formulation of resist | | | | Properties of resist | | | | |
|---|---|---|---|---|---|---|---|---|---|
| | Resin (Synthesis Example No.) (parts) | Addi-tive (parts) | Light-sensitive material (parts) | Diester ratio (%) | Effective sensit-ivity (msec) | Resolu tion (μm) | Profile | Depth of focus (μm) | Scum |
| 1 | No. 8 15 | B, 3.8 | C, 4 D, 1 | 86 | 440 | 0.35 | 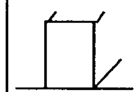 | 1.4 | Unnotice-able |
| 2 | No. 7 15 | B, 3.8 | C, 4 D, 1 | 86 | 420 | 0.35 | 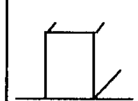 | 1.4 | Unnotice-able |
| 3 | No. 5 15 | A, 3.8 | E, 4.5 | 76 | 460 | 0.35 | 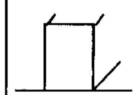 | 1.6 | Unnotice-able |
| 4 | No. 8 15 | A, 3.8 | F, 1 E, 4 | 61.8 | 320 | 0.375 | 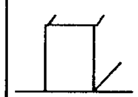 | 1.4 | Unnotice-able |
| 5 | No. 6 15 | A, 3.8 | D, 3.5 | 41 | 300 | 0.375 | 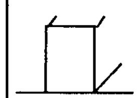 | 1.5 | Unnotice-able |

- Cont'd -

| | | | | | | | | | |
|---|---|---|---|---|---|---|---|---|---|
| 6 | No. 16<br>15 | G, 3.8 | F, 0.5<br>D, 1<br>I, 2<br>C, 1 | 45 | 320 | 0.375 | 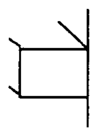 | 1.4 | Unnotice-<br>able |
| 7 | No. 14<br>15 | G, 3.5 | J, 1<br>C, 4 | 80 | 440 | 0.35 | 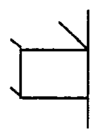 | 1.4 | Unnotice-<br>able |
| 8 | No. 13<br>15 | G, 3.5 | J, 1<br>C, 4 | 80 | 460 | 0.35 | 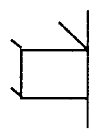 | 1.4 | Unnotice-<br>able |
| 9 | No. 15<br>15 | G, 3.5 | J, 0.5<br>C, 4.5 | 86 | 360 | 0.375 | 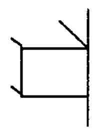 | 1.4 | Unnotice-<br>able |
| 10 | No. 14<br>15 | G, 3.5 | F, 0.5<br>J, 1<br>C, 3.5 | 68 | 300 | 0.375 | 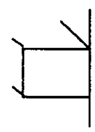 | 1.4 | Unnotice-<br>able |
| 11 | No. 14<br>15 | G, 3.5 | F, 1.5<br>C, 3.0 | 64 | 340 | 0.375 | 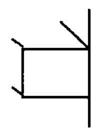 | 1.4 | Unnotice-<br>able |

In the table presented above, additives A, B and G are alkali-soluble compounds having a molecular weight of lower than 900, represented by the following formulas, respectively:

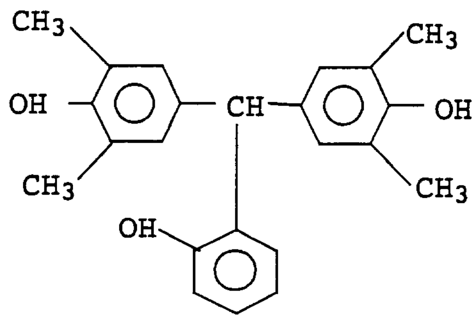

A

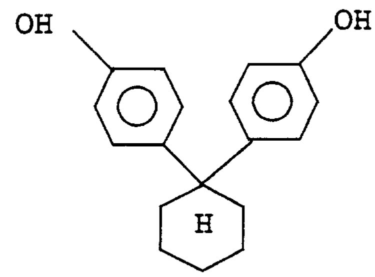

B

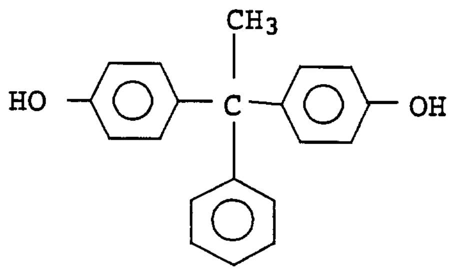

G

In the table, light-sensitive materials C to F and I to J are products obtained by reacting 1,2-naphthoquinonediazide-5-sulfonic acid chloride with each of the compounds having at least three phenolic hydroxyl groups (C' to F' and I' to J') represented by the following formulas:

C':

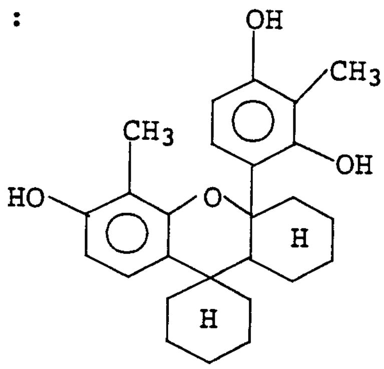

D':

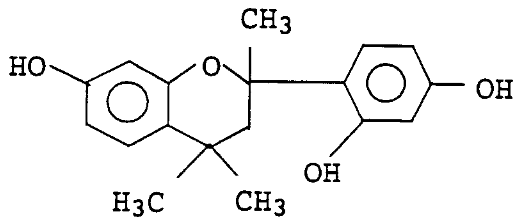

E':

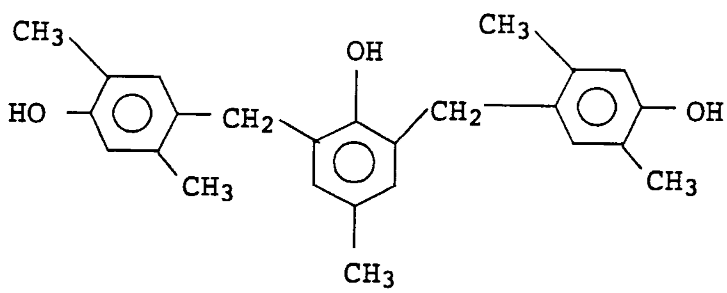

F':

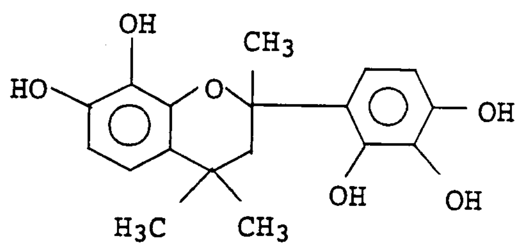

I':

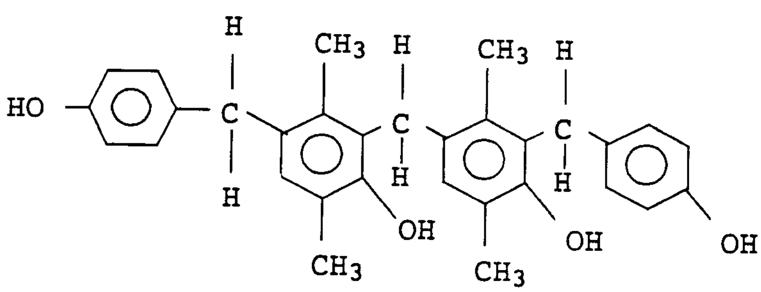

J':

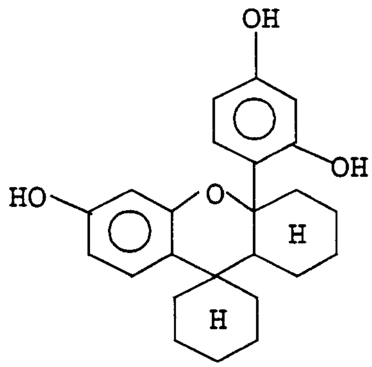

and the term "diester ratio" signifies proportion of 1,2-naphthoquinonediazide-5-sulfonic acid diester in a light-sensitive material expressed in terms of pattern area ratio in the high performance liquid chromatogram measured by the use of UV 254 nm detector.

## Claims

1. A positive resist composition comprising:
   (a) a novolac resin obtainable through a condensation reaction of an aldehyde compound with a mixture of phenol compounds comprising m-cresol, p-cresol and 2,5-xylenol,
   (b) a light-sensitive quinonediazide material containing the quinonediazidesulfonic acid diester of a compound having not less than three phenolic hydroxyl groups, provided that a peak area corresponding to said quinonediazidesulfonic acid diester of the compound having not less than three phenolic hydroxyl groups is not less than 40% of all peak areas corresponding to the light-sensitive quinonediazide material in a high performance liquid chromatograph spectrum measured with a detector for UV of 254 nm, and
   (c) an alkali-soluble compound having a molecular weight of lower than 900.

2. A positive resist composition according to Claim 1, wherein the proportion of 2,5-xylenol is from 10% to 50% by mole based on the whole moles of said mixture of phenol compounds.

3. A positive resist composition according to Claim 1 or 2, wherein said novolac resin has an area in a GPC pattern of a range in that a molecular weight as converted to polystyrene is not larger than 900 not exceeding 25% of a whole pattern area excluding the unreacted phenol compounds.

4. A positive resist composition according to any one of Claims 1 to 3, wherein the compound having at least three phenolic hydroxyl groups is an oxyflavan compound.

5. A positive resist composition according to any one of Claims 1 to 3, wherein the compound having at least three phenolic hydroxyl groups is a novolac type reaction product having 3 to 7 phenol nuclei obtained from a phenol compound and an aldehyde compound.

6. A positive resist composition according to any one of Claims 1 to 5, wherein the alkali-soluble compound having a molecular weight of lower than 900 is a compound having at least two phenolic hydroxyl groups.

7. A positive resist composition according to any one of Claims 1 to 6, wherein the content of the alkali-soluble compound having a molecular weight of lower than 900 is 3 to 40 parts by weight per 100 parts by weight of the total quantity of the novolac resin, light-sensitive quinonediazide material and alkali-soluble compound having a molecular weight of lower than 900.

8. A positive resist composition according to claim 6, wherein the compound having at least two phenolic hydroxyl groups is a compound of the formula:

   $X-\alpha-H$

wherein X represents

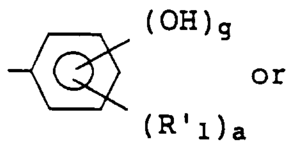

or

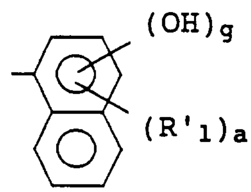

and αrepresents a divalent group containing the following repeating unit:

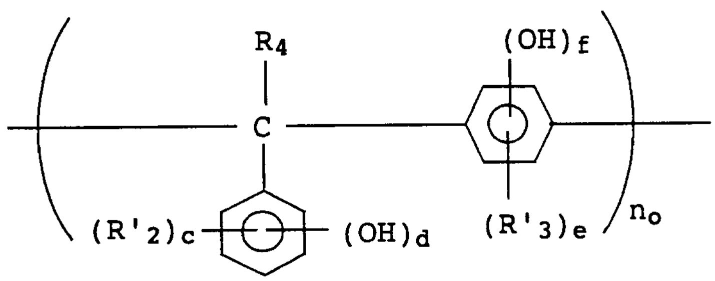

or

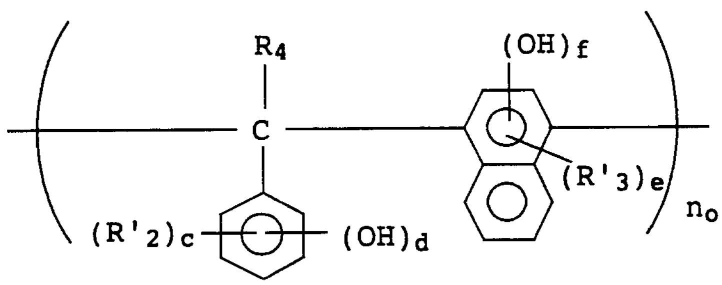

in which $n_o$ represents an integer of 1 or greater, a, b, c, d, e and f independently of one another each represents an integer of 0-3, provided that $d + f \geqq 1$, $R'_1$, $R'_2$ and $R'_3$ independently of one another each represents $C_1$-$C_{18}$ alkyl group, $C_1$-$C_{18}$ alkoxy group, carboxyl group or halogen atom, and $R_4$ represents hydrogen atom, $C_1$-$C_{18}$ alkyl group or aryl group.

**9.** A positive resist composition according to claim 6, wherein the compound having at least two phenolic hydroxyl groups is a compound of the formula:

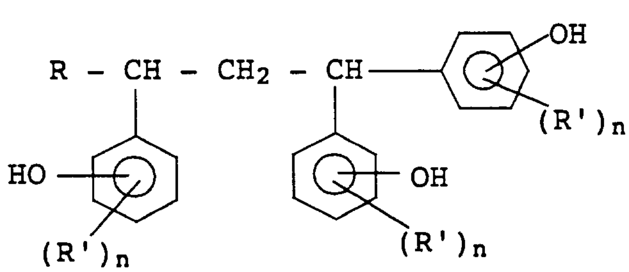

wherein R represents hydrogen atom, lower alkyl group or phenyl group, R' represents alkyl or alkoxy group, and n represents an integer of 0-3.

**10.** A positive resist composition according to claim 6, wherein the compound having at least two phenolic hydroxyl groups is a compound of the formula:

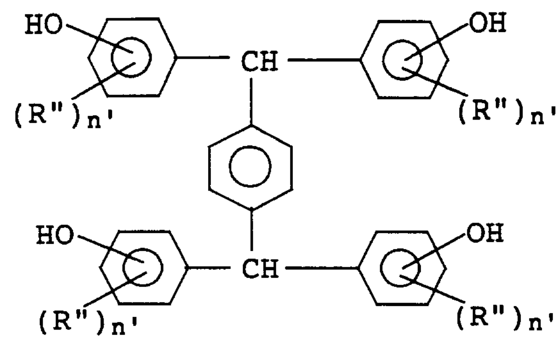

wherein R'' represents $C_1$-$C_5$ alkyl group or $C_1$-$C_5$ alkoxy group and n' represents an integer of 0-3.

**11.** A positive resist composition according to claim 4, wherein the oxyflavan compound is a compound of the formula:

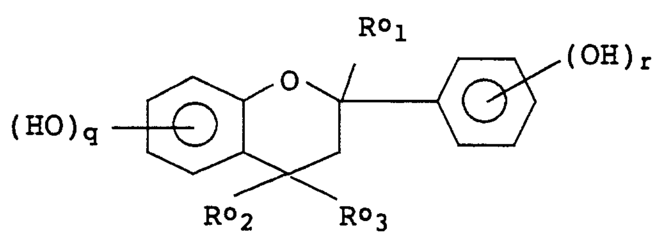

wherein q represents an integer of 0-4, r represents an integer of 1-5, and $R^o_1$ , $R^o_2$ and $R^o_3$ independently of one another each represents hydrogen atom, alkyl group, alkenyl group, cyclohexyl group or aryl group.

**12.** A positive resist composition according to claim 4, wherein the oxyflavan compound is a compound of the formula:

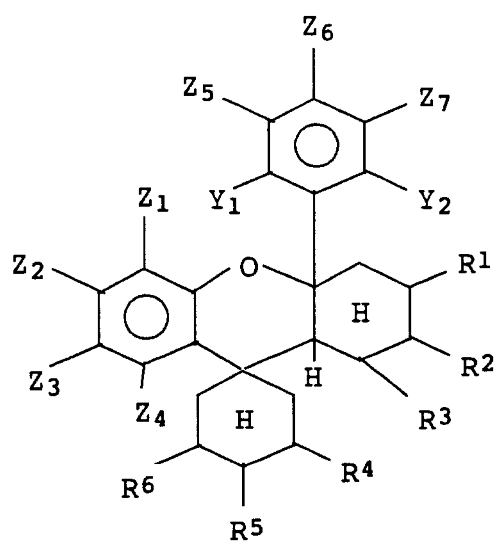

wherein $Y_1$, $Y_2$ and $Z_1$ to $Z_7$ independently of one another each represents hydrogen atom, hydroxyl group or $C_1$-$C_4$ alkyl group optionally substituted by halogen, provided that at least one of $Y_1$ and $Y_2$ is hydroxyl group and at least two of $Z_1$ to $Z_7$ are hydroxyl groups, and $R_1$ to $R_6$ independently of one another each represents hydrogen atom, $C_1$-$C_{10}$ alkyl group, $C_2$-$C_4$ alkenyl group, cycloalkyl group or aryl group.

**13.** A positive resist composition according to claim 5, wherein the novolac type reaction product having 3 to 7 phenol nuclei obtained from a phenol compound and an aldehyde compound is a compound of the formulas:

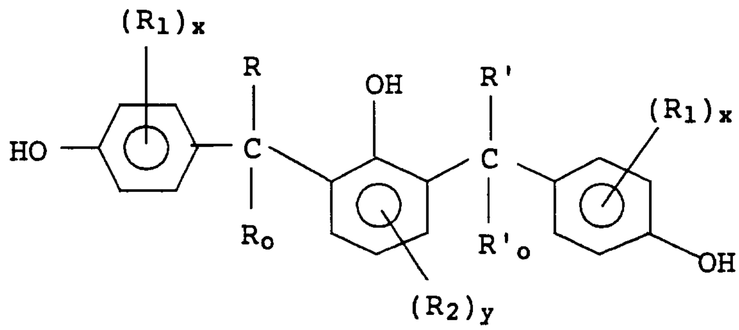

or

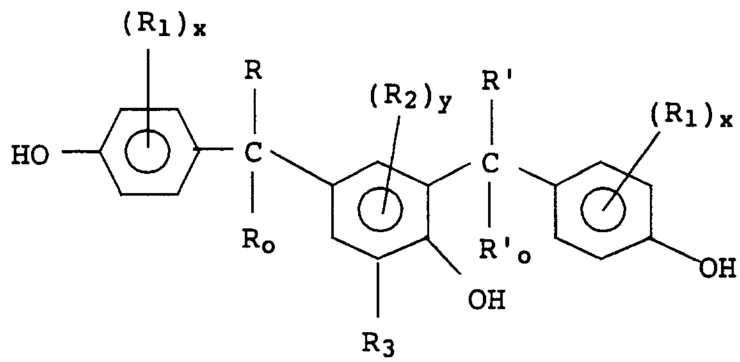

wherein $R_1$ and $R_2$ independently of one another each represents hydrogen atom, halogen atom, $-OCOR_3$ or optionally substituted alkyl or alkoxy group, in which $R_3$ represents an optionally substituted alkyl or phenyl group, x and y independently of one another each represents an integer of 1-3, and R, $R_o$, R' and $R'_o$ independently of one another each represents hydrogen atom, alkyl group or phenyl group.

**14.** A positive resist composition according to claim 5, wherein the novolac type reaction product having 3 to 7 phenol nuclei obtained from a phenol compound and an aldehyde compound is a compound of the formulas:

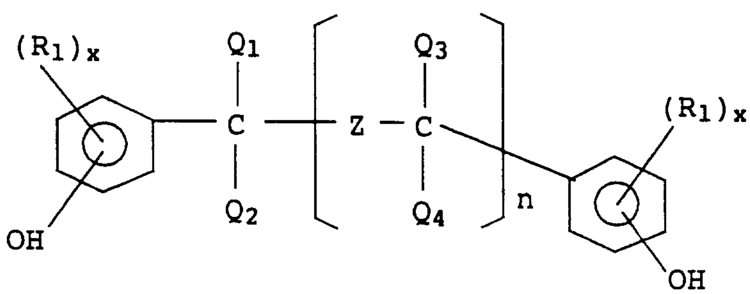

wherein $R_1$ and x are as defined above, $Q_1$ to $Q_4$ independently of one another each represents hydrogen atom, alkyl group or phenyl group, Z represents a group of the following formula:

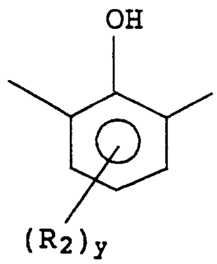

or

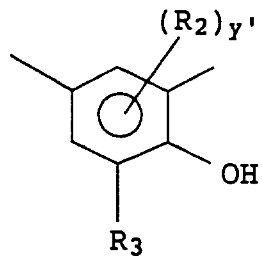

in which $R_2$ and $R_3$ are as defined above, y' represents 1 or 2, and n represents an integer of 2-5.

**15.** A positive resist composition according to any one of Claims 1 to 14, wherein said light-sensitive quinonediazide material further contains a quinonediazidesulfonic acid ester of a phenol compound having at least two phenolic hydroxyl groups, provided that a content of complete ester compound in the quinonediazidesulfonic acid ester of phenol compound having at least two phenolic hydroxyl groups is 5% or more based on the total light-sensitive quinonediazide material as expressed in terms of pattern area ratio in a high performance liquid chromatograph spectrum measured by UV detector with the wavelength of 254 nm.

**16.** A positive resist composition according to claim 6, wherein the compound having at least two phenolic hydroxyl groups is

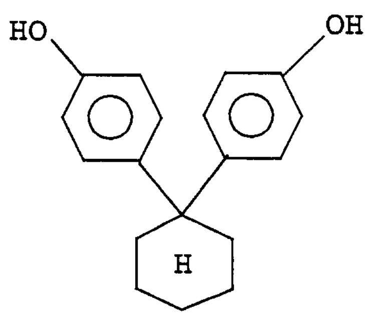

.